# FASCICULE DE BREVET EUROPEEN

(11) **EP 2 755 843 B1**
(45) Date de publication et mention de la délivrance du brevet: **19.08.2015**
(21) Numéro de dépôt: 12751526.0
(22) Date de dépôt: 30.08.2012
(51) Int. Cl.: B60R 11/00, B62D 25/14, H05K 5/00, H05K 5/02, E05D 5/10, B60K 35/00, B60K 37/04, B60K 37/06, B60R 11/02, E05D 7/10, E05D 11/06

(54) **MODULE DE CONTRÔLE INTÉGRANT UN DISPOSITIF D'AIDE À L'ASSEMBLAGE**
STEUERMODUL MIT EINER INTEGRIERTEN MONTAGEHILFE
CONTROL MODULE HAVING AN ASSEMBLY AID BUILT THEREIN

(30) Priorité: 13.09.2011 FR 1158109
(43) Date de publication de la demande: 23.07.2014
(73) Titulaire: Delphi Technologies, Inc., Troy MI 48007 (US)
(72) Inventeur: ISQUIERDO, Vincent, F-67115 Plobsheim (FR); TRAPPLER, Sebastien, F-67114 Eschau (FR)
(74) Mandataire: Delphi France SAS
(86) Numéro de dépôt international: PCT/EP2012/066886
(87) Numéro de publication internationale: WO 2013/037644

(56) Documents cités:
- WO-A1-03/095320
- DE-A1- 19 654 637
- US-A1- 2006 060 732
- US-B1- 6 186 357

## Description

### DOMAINE TECHNIQUE

L'invention est relative à un module de contrôle pouvant être intégré au tableau de bord d'un véhicule, le module comprenant des moyens de commande permettant le réglage de diverses fonctions dans un véhicule. L'invention est plus particulièrement relative à un dispositif d'aide à l'assemblage du module de contrôle. Enfin l'invention est également relative à une méthode de montage d'un module de contrôle comprenant un dispositif intégré d'aide à l'assemblage.

### ARRIERE-PLAN TECHNOLOGIQUE DE L'INVENTION

Les automobiles disposent dans leur tableau de bord et console centrale des moyens de commande de nombreux systèmes tels l'air conditionné, la radio et autres. Ces moyens qui jusqu'alors utilisaient des boutons électromécaniques de type molette rotative ou curseur à glissière sont progressivement remplacés par des capteurs de proximité sensitifs et tactiles, capteurs sans déplacement, ou à très faible course, mettant en oeuvre des films résistifs souples du type FSR (Force Sensing Resistor). Ces capteurs comprennent une large zone de détection électriquement connectée à un circuit imprimé. Les modules de contrôle sont constitués de deux parties principales, un boitier et une façade, qui doivent après assemblage être étanches à l'eau, aux poussières et autres contaminants. Pour aider à protéger le circuit imprimé celui-ci est placé dans un compartiment isolé du boitier tandis que le film souple du capteur est sur la façade sous un dispositif protecteur tel une paroi amincie et est ainsi actionnable par un utilisateur.

Ces moyens de commande de plus en plus nombreux sont intégrés à des modules de contrôle de plus en plus petits aussi, l'assemblage de ces modules de contrôle est alors de plus en plus délicat. Une opération des plus délicates consiste à connecter le film souple au circuit intégré. Effectivement les deux composants étant fixés pour l'un dans un compartiment du boitier et pour l'autre à la façade, une ouverture est prévue dans une cloison interne du boitier de sorte qu'un lien de connexion en forme de languette souple longue et étroite y soit inséré et puisse entrer dans le compartiment pour y être électriquement connecté au circuit imprimé. La manipulation délicate des composants au cours de l'assemblage demande un temps important et peut entraîner quelques dommages au niveau du lien de connexion. Le problème n'est par ailleurs pas spécifique aux capteurs résistifs mais à tout élément souple devant relier la façade au boitier. Ainsi peuvent être utilisées des fibres optiques, des câbles électriques conventionnels.

Un module de contrôle comprenant les caractéristiques du préambule de la revendication 1 et connu du document US2006/060732 A1.

Il est devenu important de proposer un dispositif simple facilitant la manipulation et assurant la qualité du montage des modules de contrôle.

### RESUME DE L'INVENTION

La présente invention résout le problème ci-dessus mentionné en proposant un module de contrôle.

L'invention propose également un procédé d'assemblage dudit module de contrôle.

L'invention propose un module de contrôle comprenant un boitier apte à recevoir un premier dispositif pouvant notamment être un circuit imprimé, une façade destinée à être placée contre le boitier, la façade étant apte à recevoir un second dispositif pouvant notamment être un capteur de proximité. Un lien de connexion relie le premier dispositif au second dispositif. Le module de contrôle est de plus pourvu d'un dispositif intégré d'aide à l'assemblage le maintenant dans un état ouvert, le boitier et la façade étant à distance l'un de l'autre en une première position. Ainsi l'assemblage du lien de connexion est facilité. Le dispositif intégré d'aide à l'assemblage permet ensuite de placer le module de contrôle dans un état fermé, la façade et le boitier ayant été approchés l'un de l'autre et étant l'un contre l'autre selon un engagement complémentaire du bord du boitier avec le pourtour de la façade. Le dispositif intégré d'aide à l'assemblage permet à la façade et au boitier de pivoter et de translater l'un par rapport à l'autre de sorte à faire passer le module de contrôle de l'état ouvert à l'état fermé. Le dispositif intégré d'aide à l'assemblage est une charnière comprenant un portique solidaire de la façade ou du boitier, portique comprenant un axe fixé entre un premier support et un second support. La charnière comprenant également un bras solidaire du boitier, respectivement de la façade, le bras se terminant en crochet ouvert pouvant être engagé sur l'axe de sorte à pivoter autour et coulisser le long de l'axe.

L'espace sous le portique, entre les supports, l'axe et la façade, respectivement le boitier, laissé libre en vue de permettre le passage du crochet lors du passage de l'état ouvert à l'état fermé forme une équerre ayant une première rainure située juste sous l'axe et une seconde rainure prolongeant la première et longeant le second support. Le crochet a, par ailleurs, une largeur inférieure à la longueur de l'axe et son engagement sur l'axe ne peut se faire qu'à l'extrémité libre de la première rainure, du côté du premier support. Dans cette position le boitier ne peut que pivoter autour de l'axe entre la première position ouverte et une deuxième position dans laquelle il est distant, parallèle et légèrement décalé par rapport la façade. Le boitier étant dans la deuxième position il peut être latéralement translaté vers une troisième position, de sorte à être distant, parallèle, et juste en face de la façade, le crochet coulissant le long de l'axe dans la première rainure jusqu'à être au droit de la seconde rainure. La seconde rainure a une largeur supérieure à la largeur du crochet et, étant dans la troisième position, le crochet peut être dégagé de l'axe et ainsi translater et approché de la façade. Le crochet peut coulisser dans la seconde rainure jusqu'à ce que le boitier et la façade soient en contact l'un de l'autre, le module de contrôle étant alors dans l'état fermé.

Par ailleurs, le dispositif intégré d'aide à l'assemblage peut comprendre deux charnières, chaque charnière, ayant un axe et un bras terminé en crochet, les deux axes étant coaxiaux de sorte à former un guidage long.

Plus précisément, le premier dispositif est un circuit imprimé et le second dispositif un capteur comprenant un film souple ayant une zone de détection connectée au circuit imprimé par une languette souple longue et étroite. Enfin, le lien de connexion peut comprendre une fibre optique.

L'invention concerne également une méthode d'assemblage d'un module de contrôle comprenant les étapes suivantes :
- pourvoir un boitier et une façade pourvu pour l'un d'un portique soutenant un axe et pour l'autre d'un bras terminé en crochet ouvert prévu pour être engagé sur l'axe,
- pourvoir un dispositif destiné à être agencé contre la façade, le dispositif ayant un lien prévu pour être connecté à un autre dispositif agencé sur le boitier,
- engager le crochet sur l'axe de sorte à former une charnière liant le boitier à la façade,
- placer le module de contrôle en un état ouvert, la façade et le boitier étant en une première position, le plus éloigné possible l'un de l'autre,
- agencer le dispositif sur la façade,
- agencer le lien (30) de connexion depuis le dispositif (24) jusqu'au boitier,
- pivoter la façade, ou le boitier, de sorte à passer de la première position à une deuxième position dans laquelle le boitier et la façade sont distant, parallèle et légèrement décalé l'un par rapport à l'autre,
- placer le module de contrôle en un état fermé, le boitier et la façade étant approché jusqu'à être en contact l'un de l'autre.

La méthode peut également comprendre l'étape suivante :
- agencer un autre dispositif dans le boitier,
- connecter le lien de connexion audit autre dispositif.

### DESCRIPTION DES FIGURES

Un mode de réalisation de l'invention est maintenant décrit par l'intermédiaire des figures suivantes.
La Figure 1 est une vue d'ensemble de l'intérieur d'un véhicule où a été placé un module de contrôle selon l'invention.
La Figure 2 est une vue éclatée du module de contrôle de la figure 1.
La Figure 3 est un détail de la figure 2 présentant une charnière du module de contrôle les éléments n'étant pas engagés.
La Figure 4 est une vue isométrique du module de contrôle de la figure 2 en cours de montage et placée dans une première position.
La Figure 5 est un détail de la figure 4 présentant la charnière du module de contrôle engagée.
La Figure 6 est une vue isométrique du module de contrôle en cours de rabattement.
La Figure 7 est un détail de la figure 6 représentant la charnière du module de contrôle.
La Figure 8 est une vue isométrique du module de contrôle en cours de montage et placée dans une deuxième position.
La Figure 9 est un détail de la figure 8 représentant la charnière du module de contrôle.
La Figure 10 est une vue isométrique du module de contrôle en cours de montage et placée dans une troisième position.
La Figure 11 est un détail de la figure 10 représentant la charnière du module de contrôle.
La Figure 12 est un détail de la charnière du module de contrôle une fois fermé.

### DESCRIPTION DES MODES DE REALISATION PRÉFÉRÉS

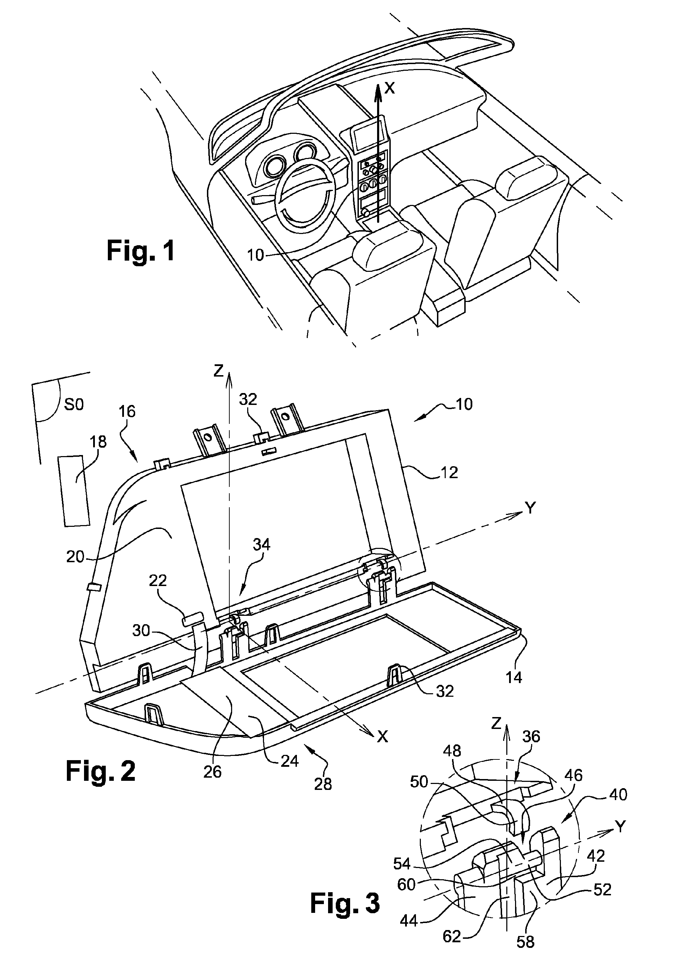

La Figure 1 représente l'intérieur d'un véhicule cabriolet, un module de contrôle 10 selon l'invention étant intégré au tableau de bord du véhicule de sorte à être accessible au conducteur. En l'occurrence le module de contrôle 10 renferme les actionneurs de commande de l'air conditionné ou de tout autre système tels la radio ou le navigateur. Cette représentation n'est en aucun cas limitative de l'invention qui est indépendante du type d'environnement choisi, ici un véhicule, et du type de commande pilotable depuis les actionneurs du module de contrôle.
La Figure 2 est une vue éclatée du module de contrôle 10 où sont distingués les composants principaux. Le module de contrôle 10 comprend un boitier 12 destiné à être fermé par une façade 14. Le module de contrôle 10 peut optionnellement comprendre une large ouverture centrale, ici représentée rectangulaire permettant la visualisation d'un écran d'information. Le boitier 12 a un fond entouré d'un bord. Il est pourvu sur les côtés de l'ouverture centrale de compartiments protégés 16 destinés à recevoir chacun un circuit imprimé 18. Chaque compartiment 16 est protégé des impuretés et des corps étrangers, tels l'eau ou la poussière, par une cloison interne 20 au boitier globalement parallèle au fond du boitier 12. Une petite ouverture 22 est pratiquée dans la cloison interne 20. Par ailleurs, les boutons de commandes sont des capteurs de pression 24 sans déplacement, à effleurement. Ils comprennent un film résistif 26 souple multicouche dont la résistance décroit sous l'effet d'une légère pression. De tels films sont connus parfois sous leur désignation anglaise Force Sensing Resistor (FSR). Le capteur résistif 24 comprend une zone de détection 28 suffisamment large pour qu'un utilisateur la trouve facilement et actionne la commande désirée. La zone de détection 28 est prolongée par une languette 30 longue et souple destinée à être connectée au circuit imprimé 18 qui assure l'alimentation électrique du capteur 24. Le boitier 12 et la façade 14 devant être finalement fixés l'un à l'autre, le bord du boitier 12 et le pourtour de la façade 14 sont conçus pour permettre un engagement complémentaire de l'un avec l'autre. La fixation est assurée par des clips 32 complémentaires mâles et femelles placés sur le bord du boitier 12 et sur le pourtour la façade 14.

Pour faciliter le montage, le module de contrôle 10 est pourvu d'un dispositif d'aide à l'assemblage 34 qui permet d'articuler le boitier 12 et la façade 14 l'un par rapport à l'autre au moyen de deux charnières 36, 38, alignées. Chaque charnière 36, 38, est constituée d'une part d'un portique 40 comprenant deux supports 42, 44, soutenant un axe 46 et, d'autre part, d'un bras 48 dont l'extrémité libre est courbée en forme de crochet 50. Le crochet 50 et l'axe du portique 40 sont prévus pour coopérer et former une charnière 36, 38. La Figure 3 détaille les éléments de la charnière 36, non assemblée.

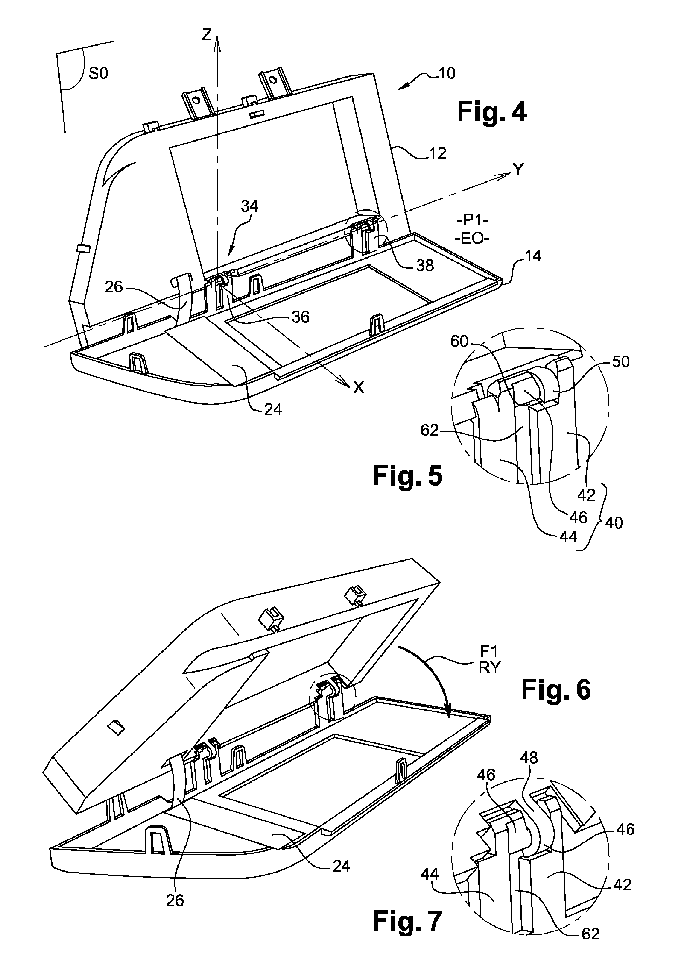

Les pièces sont repérées dans un repère direct (X, Y, Z) tel que représenté sur les figures. L'axe 46 du portique 40 s'étend selon l'axe Y, le plan (X, Y), qui par soucis de simplification et sans limiter pour autant la description sera également appelé « plan horizontal », correspondant au plan dans lequel est placée la façade 14 dans les Figures 2 à 12. Le fond du boitier 12 est quant à lui placé, dans les Figures 2 et 4, dans un plan S0 formant un angle obtus avec le plan horizontal.

Dans la description le portique 40 est solidaire de la façade 14, s'en étendant dans le plan vertical (Y, Z) perpendiculairement au plan principal (X, Y) de la façade 14. Le bras 48 terminé en crochet 50 est quant à lui solidaire du boitier 12 s'étendant à la normale du plan principal du boitier 12.

Il est évident qu'une disposition symétrique avec le portique 40 solidaire du boitier 12 et le bras 48 terminé en crochet 50 solidaire de la façade 14 est possible.

La Figure 4 représente le module de contrôle 10, les éléments préalablement présentés étant liés les uns aux autres. Les crochets 50 coopèrent avec les axes 46 de sorte que le boitier 12 et la façade 14 soient articulés et se trouvent placés en une première position P1 correspondant à un état ouvert EO du module de contrôle 10. Plus facilement observable sur le détail des Figures 3 et 5, l'axe 46 comprend une première section 52 cylindrique à proximité du premier support 42 autour de laquelle le crochet 50 peut être engagé. L'axe 46 se poursuit en une seconde section 54 plus large que la première section 52 et s'étendant jusqu'au second support 44. L'élargissement de la seconde section 54 relativement à la première section 52 de l'axe 46 conserve le diamètre de la première section 52 et s'étend au-dessus du portique 40 de sorte qu'en état ouvert EO, le crochet 50 étant engagé autour de la première section 52 de l'axe y est maintenu par l'élargissement de la seconde section 54. Le premier support 42 comprend également un élargissement 58 s'étendant sous le portique 40 depuis le pied du support jusque sous l'axe 46. De fait, sous le portique 40, l'espace laissé libre prend la forme de deux rainures 60, 62, perpendiculaires. La première rainure 60 est située juste sous l'axe 46 s'étendant selon l'axe Y et la seconde rainure 62 longe le second support 44 selon l'axe Z. En première position P1, le crochet 50 est engagé autour de la première section de l'axe 52, l'extrémité libre 64 du crochet s'engageant sous l'axe 46 dans la première rainure 60. En cette position, il est facile à un opérateur de procéder aux opérations délicates de montage telles que l'agencement du capteur 24 et le passage de la languette souple 30 au travers de la petite ouverture 22 de la cloison interne 20 de sorte à la faire entrer dans le compartiment 16 en vue de la connexion électrique avec le circuit imprimé 18. La charnière 36 maintient le boitier 12 et la façade 14 à distance l'un de l'autre et constitue le dispositif d'aide à l'assemblage 34 du module de contrôle 10.

Comme précédemment mentionné, le dispositif d'aide à l'assemblage 34 ainsi constitué peut être utilisé dès lors que des opérations délicates doivent être réalisées dans un espace réduit, tel celui du module de contrôle 10. La languette 30 souple du film résistif 26 peut être selon les cas un câble électrique fin ou une fibre optique ou tout autre lien de connexion.

La Figure 6 représente le module de contrôle 10 en une position intermédiaire en cours de fermeture après la fin des opérations délicates de montage. Le boitier 12 et la façade 14 sont rabattus l'un vers l'autre par rotation RY autour de l'axe Y, selon la flèche courbe F1 de la Figure 5. Le crochet 50 tourne autour de la première section de l'axe 52 tel que détaillé sur la Figure 6, l'extrémité libre 64 du crochet s'engageant sous l'axe 46 dans la première rainure 60.

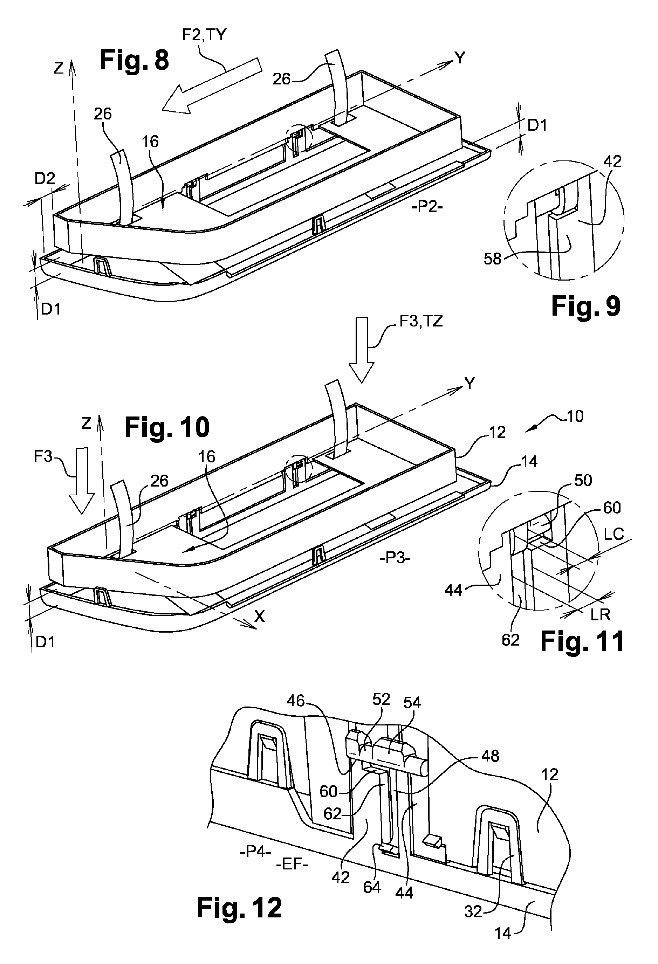

La Figure 9 représente le module de contrôle 10 en une deuxième position P2 atteinte à la fin de la rotation RY précédemment décrite. Le boitier 12 et la façade 14 sont parallèles l'un à l'autre. Ils demeurent cependant à distance D1 l'un de l'autre, la distance D1 étant mesurée selon l'axe Z, et légèrement décalés D2 selon l'axe Y. Le crochet 50 est toujours engagé autour de la première section de l'axe 52, comme détaillé sur la Figure 8, et la rotation RY depuis la première position P1 jusque vers la deuxième position P2 l'a largement engagé sous l'axe 46 dans la première rainure 60. Cependant le crochet 50 qui était jusqu'à présent maintenu autour de la première section 52 de l'axe 46 par l'élargissement de la seconde section 54 de l'axe et qui ne pouvait que tourner autour de cette première section 52 peut maintenant translater selon l'axe Y dans la première rainure 60, suivant une translation TY, dans le sens de la flèche F2 de la Figure 7, depuis la première section 52 de l'axe jusque vers la deuxième section 54 de l'axe 46.

La Figure 10 représente le module de contrôle 10 en une troisième position P3 atteinte après que le crochet 50 ait translaté TY horizontalement selon l'axe Y depuis la première section 52 jusqu'à la seconde section 54 de l'axe. Le boitier 12 et la façade 14 se trouvent toujours dans des plans horizontaux parallèles et toujours à distance D1 l'un de l'autre mais sont maintenant l'un en face de l'autre, le décalage D2 précédant ayant été comblé par la translation TY du passage de la deuxième P2 à la troisième position P3. La Figure 10 détaille la configuration de la charnière 36, en troisième position P3. Le crochet 50 a coulissé le long de l'axe 46 depuis la première section 52 jusqu'à la seconde section 54 de l'axe 46 et est placé contre le second support 44. En cet endroit la première rainure 60 rejoint la seconde rainure 62 qui longe le second support 44 tout au long de celui-ci. La seconde rainure 62 a une largeur LR légèrement supérieure à la largeur LC du crochet 50 de sorte que, comme indiqué par les flèches F3 de la Figure 10, le boitier 12 et la façade 14 peuvent être rapprochés l'un de l'autre par translation verticale TZ du boitier 12. Le crochet 50 se dégage alors de l'axe 46 et peut coulisser dans la seconde rainure 62.

Une quatrième et dernière position P4 fermée est simplement détaillée par la Figure 12 où, vue sous un angle différent de celui des figures précédentes, le crochet 50 a coulissé dans la seconde rainure 62 de sorte que le bord du boitier 12 et le pourtour de la façade 14 se trouvent en contact complémentaire l'un avec l'autre. Les clips 32 mâles et femelles sont alors engagés de sorte à fixer les pièces et fermer définitivement le module de contrôle 10.

Alternativement à la fermeture par clips, d'autres moyens tels des systèmes à vis, à rivets voire une fixation par collage est possible.

La description qui précède détaille une charnière 36. Un mode de réalisation préféré comprend deux charnières similaires 36, 38, dont les axes sont alignés de sorte à fournir une meilleure stabilité lors des manipulations du montage. Alternativement, le dispositif intégré d'aide à l'assemblage 34 du module de contrôle 10 pourrait ne comprendre qu'un seul axe 46 long ayant plusieurs sections et plusieurs crochets 50 coopérant avec les différentes sections du même axe 46. Il est également possible de n'avoir qu'une seule charnière 36 de largeur importante de sorte à assurer à elle seule la stabilité nécessaire. Par ailleurs, un module de contrôle 10 peut comprendre un ou plusieurs capteurs 24 chacun étant connecté à un circuit imprimé 18 et le boitier 12 peut comprendre plusieurs compartiments 16.

Le module de contrôle 10 décrit comprend un capteur d'effort 24 connecté via une languette 30 souple. Alternativement, et sans influence sur l'invention du dispositif d'aide à l'assemblage 34, la languette 30 peut être remplacée par exemple par une câble électrique ou par une fibre optique reliant une source lumineuse située dans le boitier 12 à un afficheur solidaire de la façade 14. Enfin une telle charnière 36, objet de l'invention, est utilisable pour n'importe quel dispositif dans lequel deux pièces doivent être maintenues dans une position ouverte avant d'être rabattues l'une vers l'autre. Dans le cas présent le module de contrôle 10 est destiné à être fermé mais, la charnière 36 de l'invention peut aider dans le cas de dispositifs devant être régulièrement manipulés et ouverts puis fermés tels que pour des opérations de maintenance et d'entretien.

## Revendications

1. Module de contrôle (10) comprenant
- un boitier (12) apte à recevoir un premier dispositif (18) pouvant notamment être un circuit imprimé,
- une façade (14) destinée à être placée contre le boitier (12), la façade (12) étant apte à recevoir un second dispositif (24) pouvant notamment être un capteur d'effort,
- un lien de connexion (30) reliant le premier dispositif (18) au second dispositif (24),
le module de contrôle (10) étant de plus pourvue d'un dispositif intégré d'aide à l'assemblage (34) maintenant le module de contrôle (10) dans un état ouvert (EO), le boitier (12) et la façade (14) étant à distance l'un de l'autre en une première position (P1) et ce de sorte à faciliter entre autre l'assemblage du lien de connexion (30), le dispositif intégré d'aide à l'assemblage (34) permettant ensuite de placer le module de contrôle (10) dans un état fermé (EF), la façade (14) et le boitier (12) ayant été approchés l'un de l'autre et étant l'un contre l'autre,
**caractérisée en ce que** le dispositif intégré d'aide à l'assemblage (34) est une charnière (36) comprenant un portique (40) solidaire de la façade (14), respectivement du boitier (12), portique (40) comprenant un axe (46) fixé entre un premier support (42) et un second support (44), la charnière (36) comprenant également un bras (48) solidaire du boitier (12), respectivement de la façade (14), le bras (48) se terminant en crochet (50) ouvert pouvant être engagé sur l'axe (46) de sorte à pivoter (RY) autour et coulisser (TY) le long de l'axe (46) et dans lequel,
l'espace sous le portique (40), entre les supports (42, 44), l'axe (46) et la façade (14), respectivement le boitier (12), laissé libre en vue de permettre le passage du crochet (50) lors du passage de l'état ouvert (EO) à l'état fermé (EF) forme une équerre ayant une première rainure (60) située juste sous l'axe (46) et une seconde rainure (62) prolongeant la première (60) et longeant le second support (44).

2. Module de contrôle (10) selon la revendication précédente dans lequel le dispositif intégré d'aide à l'assemblage (34) permet à la façade (14) et au boitier (12) de pivoter (RY) et de translater (TY, TZ) l'un par rapport à l'autre de sorte à faire passer le module de contrôle (10) de l'état ouvert (EO) à l'état fermé (EF).

3. Module de contrôle (10) selon une quelconque des revendications précédentes dans lequel le crochet (50) a une largeur (LC) inférieure à la longueur de l'axe et l'engagement du crochet (50) sur l'axe (46) ne peut se faire qu'à l'extrémité libre de la première rainure (60), du côté du premier support (42), position dans laquelle le boitier (12) ne peut que pivoter (RY) autour de l'axe (46) entre la première position (P1) ouverte et une deuxième position (P2) dans laquelle il est distant (D1), parallèle et légèrement décalé (D2) par rapport la façade (14).

4. Module de contrôle (10) selon la revendication 3 dans lequel le boitier (12) étant dans la deuxième position (P2) il peut être latéralement translaté (TY) vers une troisième position (P3), de sorte à être distant (D1), parallèle, et juste en face de la façade (14), le crochet (50) coulissant le long de l'axe (46) dans la première rainure (60) jusqu'à être au droit de la seconde rainure (62).

5. Module de contrôle (10) selon la revendication 4 dans lequel la seconde rainure (62) a une largeur (LR) supérieure à la largeur (LC) du crochet (50) de sorte que le module de contrôle (10) étant dans la troisième position (P3), le crochet (50) puisse être dégagé de l'axe (46) et le boitier (12) translaté et approché de la façade (14), le crochet (50) coulissant dans la seconde rainure (62), jusqu'à ce que le boitier (12) et la façade (14) soient en contact l'un de l'autre, le module de contrôle (10) étant alors dans l'état fermé (EF).

6. Module de contrôle (10) selon une quelconque des revendications précédente dans lequel le dispositif intégré d'aide à l'assemblage (34) comprend deux charnières (36, 38), chaque charnière (36, 38) ayant un axe (46) et un bras (48) terminé en crochet (50), les deux axes (46) étant coaxiaux de sorte à former un guidage long.

7. Module de contrôle (10) de contrôle selon une quelconque des revendications précédentes dans lequel le premier dispositif (18) est un circuit imprimé et le second dispositif (24) un capteur comprenant un film souple (26) ayant une zone de détection (28) connectée au circuit imprimé (18) par une languette (30) souple longue et étroite.

8. Module de contrôle (10) selon une quelconque des revendications précédentes dans lequel le lien de connexion (30) comprend une fibre optique.

## Patentansprüche

1. Steuermodul (10), enthaltend:
- ein Gehäuse (12), das dazu geeignet ist, eine erste Vorrichtung (18) aufzunehmen, die insbesondere eine gedruckte Schaltung sein kann,
- eine Frontblende (14), die dazu bestimmt ist, an das Gehäuse (12) angesetzt zu werden, wobei die Frontblende (12) dazu geeignet ist, eine zweite Vorrichtung (24) aufzunehmen, die insbesondere ein Kraftsensor sein kann,
- eine Verbindung (30), welche die erste Vorrichtung (18) mit der zweiten Vorrichtung (24) verbindet,
wobei das Steuennodul (10) ferner mit einer integrierten Montagehilfsvorrichtung (34) versehen ist, welche das Steuermodul (10) in einem offenen Zustand (EO) hält, wobei das Gehäuse (12) und die Frontblende (14) in einer ersten Stellung (P1) voneinander beabstandet sind, und zwar derart, dass unter anderem das Montieren der Verbindung (30) erleichtert wird, wobei die integrierte Montagehilfsvorrichtung (34) dann gestattet, das Steuermodul (10) in einen geschlossenen Zustand (EF) zu bringen, wobei die Frontblende (14) und das Gehäuse (12) einander angenähert wurden und aneinander anliegen, **dadurch gekennzeichnet, dass** die integrierte Montagehilfsvorrichtung (34) ein Scharnier (36) ist, das einen fest mit der Frontblende (14) bzw. mit dem Gehäuse (12) verbundenen Tragrahmen (40) aufweist, welcher Tragrahmen (40) eine Achse (46) aufweist, die zwischen einem ersten Träger (42) und einem zweiten Träger (44) befestigt ist, wobei das Scharnier (36) auch einen Arm (48) aufweist, der fest mit dem Gehäuse (12) bzw. mit der Frontblende (14) verbunden ist, wobei der Arm (48) mit einem offenen Haken (50) endet, der an der Achse (46) eingreifen kann, so dass er um die Achse (46) herumschwenken (RY) und sich entlang dieser verschieben (TY) kann, und wobei
der Raum unter dem Tragrahmen (40) zwischen den Trägern (42, 44), der Achse (46) und der Frontblende (14) bzw. dem Gehäuse (12), der freigelassen wird, um den Durchtritt des Hakens (50) beim Übergang von dem offenen Zustand (EO) in den geschlossenen Zustand (EF) zu gestatten, einen Winkel bildet, der eine erste Nut (60) aufweist, die gerade unter der Achse (46) liegt, sowie eine zweite Nut (62), welche die erste (60) fortsetzt und sich entlang des zweiten Trägers (44) erstreckt.

2. Steuermodul (10) nach dem vorangehenden Anspruch, wobei die integrierte Montagehilfsvorrichtung (34) es der Frontblende (14) und dem Gehäuse (12) gestattet, sich zueinander zu verschwenken (RY) und zu verschieben (TY, TZ), so dass das Steuermodul (10) vom offenen Zustand (EO) in den geschlossenen Zustand (EF) überführt wird.

3. Steuermodul (10) nach einem der vorangehenden Ansprüche, wobei der Haken (50) eine Breite (LC) hat, die geringer als die Länge der Achse ist, und das Eingreifen des Hakens (50) an der Achse (46) nur am freien Ende der ersten Nut (60) auf der Seite des ersten Trägers (42) erfolgen kann, in welcher Stellung das Gehäuse (12) nur um die Achse (46) herum zwischen der ersten offenen Stellung (P1) und einer zweiten Stellung (P2) verschwenken kann (RY), in welcher es beabstandet (D1), parallel und geringfügig versetzt (D2) bezüglich der Frontblende (14) ist.

4. Steuermodul (10) nach Anspruch 3, wobei das in der zweiten Stellung (P2) befindliche Gehäuse (12) zu einer dritten Stellung (P3) hin seitlich verschoben werden kann (TY), so dass es beabstandet (D1), parallel und genau gegenüberliegend zur Frontblende (14) ist, wobei der Haken (50) entlang der Achse (46) in der ersten Nut (60) gleitbeweglich ist, bis er sich im Bereich der zweiten Nut (62) befindet.

5. Steuermodul (10) nach Anspruch 4, wobei die zweite Nut (62) eine Breite (LR) hat, die größer als die Breite (LC) des Hakens (50) ist, so dass bei in der dritten Stellung (P3) befindlichem Steuermodul (10) der Haken (50) von der Achse (46) freigegeben werden kann und das Gehäuse (12) verschoben und der Frontblende (14) angenähert werden kann, wobei der Haken (50) in der zweiten Nut (62) gleitbeweglich ist, bis das Gehäuse (12) und die Frontblende (14) in Kontakt miteinander sind, wobei das Steuermodul (10) dann in dem geschlossenen Zustand (EF) ist.

6. Steuermodul (10) nach einem der vorangehenden Ansprüche, wobei die integrierte Montagehilfsvorrichtung (34) zwei Scharniere (36, 38) aufweist, wobei jedes Schmier (36, 38) eine Achse (46) und einen Arm (48) enthält, der mit einem Haken (50) endet, wobei die beiden Achsen (46) koaxial verlaufen, so dass sie eine lange Führung bilden.

7. Steuermodul (10) nach einem der vorangehenden Ansprüche, wobei die erste Vorrichtung (18) eine gedruckte Schaltung ist und die zweite Vorrichtung (24) ein Sensor mit einer nachgiebigen Folie (26) mit einem Detektionsbereich (28) ist, der über eine nachgiebige, lang und schmal ausgeführte Zunge (30) mit der gedruckten Schaltung (18) verbunden ist.

8. Steuermodul (10) nach einem der vorangehenden Ansprüche, wobei die Verbindung (30) einen Lichtwellenleiter enthält.

## Claims

1. Control module (10) comprising
- a unit (12) able to accept a first device (18) that may notably be a printed circuit,
- a façade (14) intended to be placed against the unit (12), the façade (12) being able to accept a second device (24) that may notably be a load sensor,
- a connection tie (30) connecting the first device (18) to the second device (24),
the control module (10) additionally being provided with an in-built assembly-aid device (34) that holds the control module (10) in an open state (EO), the unit (12) and the façade (14) being some distance away from one another in a first position (P1), the purpose of this being, amongst other things, to make it easier for the connection tie (30) to be assembled, the in-built assembly-aid device (34) then allowing the control module (10) to be placed in a closed state (EF), the façade (14) and the unit (12) having been brought closer to one another and being against one another, **characterized in that** the in-built assembly-aid device (34) is a hinge (36) comprising a portal frame (40) secured to the façade (14) or, respectively, to the unit (12), the portal frame (40) comprising a pin (46) fixed between a first support (42) and a second support (44), the hinge (36) also comprising an arm (48) secured to the unit (12) or, respectively, to the façade (14), the arm (48) ending in an open hook (50) that can be engaged over the pin (46) so as to pivot (RY) around and slide (TY) along the pin (46), and in which
the space under the portal frame (40), between the supports (42, 44), the pin (46) and the façade (14) or, respectively, the unit (12), which space is left free so as to allow the passage of the hook (50) during the transition from the open state (EO) to the closed state (EF), forms a square bracket having a first slot (60) situated just beneath the pin (46) and a second slot (62) extending the first (60) and running alongside the second support (44).

2. Control module (10) according to the preceding claim, in which the in-built assembly-aid device (34) allows the façade (14) and the unit (12) a pivoting (RY) and translational (TY, TZ) movement one relative to the other so as to cause the control module (10) to make the transition from the open state (EO) to the closed state (EF).

3. Control module (10) according to either one of the preceding claims, in which the hook (50) has a width (LC) less than the length of the pin and the hook (50) can be engaged over the pin (46) only at the free end of the first groove (60), on the side of the first support (42), in which position the unit (12) can only pivot (RY) about the pin (46) between the open first position (P1) and a second position (P2) in which it is distant (D1) from, parallel to and slightly offset (D2) from the façade (14).

4. Control module (10) according to Claim 3, in which when the unit (12) is in the second position (P2) it can undergo a lateral translational movement (TY) towards a third position (P3) so as to be distant (D1) from, parallel to, and just opposite the façade (14), the hook (50) sliding along the pin (46) in the first slot (60) until it comes into alignment with the second slot (62).

5. Control module (10) according to Claim 4, in which the second slot (62) has a width (LR) greater than the width (LC) of the hook (50) so that when the control module (10) is in the third position (P3), the hook (50) can be disengaged from the pin (46) and the unit (12) can undergo a translational movement closer to the façade (14), the hook (50) sliding in the second slot (62) until the unit (12) and the façade (14) are in contact with one another, the control module (10) then being in the closed state (EF).

6. Control module (10) according to any one of the preceding claims, in which the in-built assembly-aid device (34) comprises two hinges (36, 38), each hinge (36, 38) having a pin (46) and an arm (48) ending in a hook (50), the two pins (46) being coaxial so as to form a long guide.

7. Control module (10) according to any one of the preceding claims, in which the first device (18) is a printed circuit and the second device (24) is a sensor comprising a flexible film (26) having a detection zone (28) connected to the printed circuit (18) by a flexible long narrow tongue (30).

8. Control module (10) according to any one of the preceding claims, in which the connection tie (30) comprises an optical fibre.
